Europäisches Patentamt

European Patent Office

Office européen des brevets

(19)

(11) EP 0 887 844 A2

(12) EUROPÄISCHE PATENTANMELDUNG

(43) Veröffentlichungstag:
30.12.1998 Patentblatt 1998/53

(51) Int. Cl.$^6$: H01L 21/285

(21) Anmeldenummer: 98111916.7

(22) Anmeldetag: 26.06.1998

(84) Benannte Vertragsstaaten:
AT BE CH CY DE DK ES FI FR GB GR IE IT LI LU
MC NL PT SE
Benannte Erstreckungsstaaten:
AL LT LV MK RO SI

(30) Priorität: 27.06.1997 DE 19727457

(71) Anmelder:
SIEMENS AKTIENGESELLSCHAFT
80333 München (DE)

(72) Erfinder:
• Hintermaier, Frank, Dr.
81373 München (DE)
• Mazure-Espejo, Carlos, Dr.
85604 Zorneding (DE)

(54) **Verfahren zum Herstellen einer Barrierenschicht auf einem Kontaktplug**

(57)     Das Verfahren sieht vor, auf dem Kontaktplug
(16) des Halbleiterkörpers (10) eine Barrierenschicht
(28; 30a) anzuordnen, um eine Oxidation des Kontaktplugs (16) zu vermeiden. Die Barrierenschicht (28;
30a) wird erfindungsgemäß durch chemische Reaktion
eines vorstrukturierten, metallischen Übergangsmaterials (30) mit mindestens einem Reaktionspartner (32)
erzeugt.

Fig.1

EP 0 887 844 A2

**Beschreibung**

Die Erfindung betrifft ein Verfahren zum Herstellen einer Barrierenschicht auf einem in einem Halbleiterkörper angeordneten und mindestens annähernd bis zu einer Hauptfläche des Halbleiterkörpers reichenden Kontaktplug sowie ein Halbleiterbauelement mit einer solchen Barrierenschicht.

Halbleiterspeicheranordnungen bestehen aus einer Vielzahl von Speicherzellen, die jeweils einen Auswahltransistor und einen mit dem Auswahltransistor verbundenen Speicherkondensator aufweisen. Ein Grundproblem bei der fortschreitenden Miniaturisierung von integrierten Schaltungen ist die Integration dieser Speicherkondensatoren. Da die Kapazität ihrer Querschnittsfläche und damit der von ihnen belegten Substratoberfläche proportional ist, lassen sie sich nicht in derselben Weise miniaturisieren wie z. B. Transistoren.

Ein Ansatz zur Lösung dieses Problems besteht darin, als Dielektrikum des Speicherkondensators nicht mehr einen gesperrt betriebenen P-N-Übergang oder die in der MIS- bzw. MOS-Technik stets vorhandene Isolierschicht (Siliziumdioxid und/oder Siliziumnitrid) zu verwenden, sondern gezielt eine dielektrische Schicht aus einem Material mit höherer Dielektrizitätskonstante auf das Halbleitersubstrat aufzubringen.

Die Materialien mit hoher Dielektrizitätskonstante lassen sich gemäß folgender Tabelle in zwei verschiedene Gruppen einordnen:

Tabelle

|  | paraelektrische Materialien | ferroelektrische Materialien |
|---|---|---|
| Eigenschaft | nur hohes $\varepsilon$, lineare Beziehung zwischen Polarisation des Dielektrikums und angelegtem elektrischen Feld | hohes $\varepsilon$ + nicht lineare Beziehung zwischen Polarisation des Dielektrikums und angelegtem elektrischen Feld. Hystereseschleife zwischen Polarisation und E-Feld |
| Beispiele | BST (= (Ba, Sr)TiO3 | PZT (= Pb(Zr, Ti)O3, SBT (= SrBi2Ta2O9), BT (= Bi4Ti3O11) |
| Anwendung | zukünftige DRAM Generationen | FRAM und Smartcards, beides sind nicht flüchtige Speicher. |
| Speicherung der Information | durch Ladung | durch Polarisation |
| Vorteile |  | - kein refresh nötig - Information bleibt nach Anschalten der Versorgungsspannung erhalten. |

FRAMs stellen eine Weiterentwicklung der DRAMs dar: durch Austausch des dielektrischen oder paraelektrischen Materials zwischen den Platten gegen ein Ferroelektrikum wird erreicht, daß die Information als Polarisation gespeichert wird und nach Abschalten der Stromquelle erhalten bleibt. Der prinzipielle Aufbau (Auswahltransistor, Stack-Kondensator, etc.) ist bei DRAM und FRAM gleich, ebenso viele der Integrationsprobleme. Deswegen ist es zweckmäßig z. B. Si3N4 durch BST zu ersetzen, welches ein $\varepsilon$ von bis zu 600 hat.

Bei der Verarbeitung oxidkeramischer Materialien treten jedoch Probleme auf, weil die Schichtmaterialien in der Regel in einer sauerstoffhaltigen Atmosphäre abgeschieden werden. Dies führt dazu, daß das an das Dielektrikum angrenzende Elektrodenmaterial oxidiert, wodurch dessen Leitfähigkeit und damit die Zuverlässigkeit der gesamten Schaltung beeinträchtigt wird. Insbesondere werden die Kontaktplugs des Halbleiterkörpers gestört. Dieses Problem tritt auch dann auf, wenn für die Speicherkondensatoren das sogenannte Stackprinzip verfolgt wird, bei dem die untere Elektrode, die z. B. aus Platin bestehen kann, in direktem Kontakt mit dem Kontaktplug steht. Die obere Elektrode, die z. B. ebenfalls aus Platin besteht, wird als sogenannte Commonplate ausgeführt.

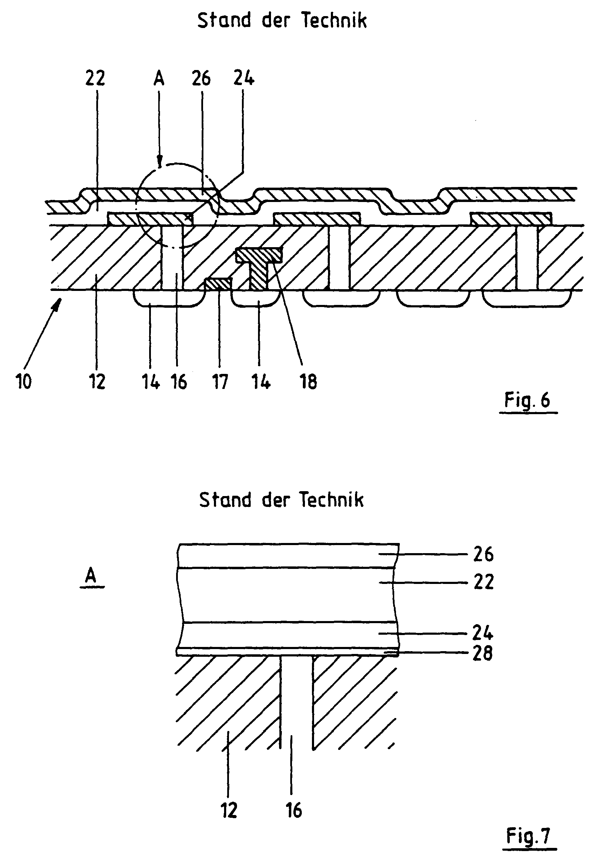

In Fig. 6 ist ausschnittsweise ein Halbleiterkörper für ein solches Halbleiterbauelement im Schnitt dargestellt. Der Halbleiterkörper ist mit dem Bezugszeichen 10 und die Kontaktplugs mit den Bezugszeichen 16 bezeichnet. Zwischen den Kontaktplugs 16 befindet sich eine Oxidschicht, z. B. TEOS. Zusätzlich sind in den Halbleiterkörper 10 dotierte Wannen 14 eingebettet, die teilweise von den Kontaktplugs 16 und Bitleitungen 18 kontaktiert werden. Zwischen zwei Wannen 14 befindet sich, jeweils eingebettet in die Oxidschicht 12, eine Wortleitung 17. Auf der oberen Hauptfläche des Halbleiterkörpers 10 sind die beiden Elektrodenschichten mit dazwischen liegender Dielektrikumsschicht 22 angeordnet zur Bildung der Speicherkondensatoren. Die obere Elektrodenschicht ist mit dem Bezugszeichen 26 und die untere, strukturierte Elektrodenschicht mit dem Bezugszeichen 24 bezeichnet. Nach Prozessierung der unteren Elektrode 24 (Abscheidung, Strukturierung, etc.) wird das Dielektrikumsmaterial abgeschieden. Dies kann z.B. durch einen physikalischen Abscheideprozess, z.B. Sputtern geschehen. In bevorzugter Weise wird hierfür jedoch ein chemischer Gasphasenabscheideprozess eingesetzt (CVD). In der Regel ist Sauerstoff bei der Abscheidung des Dielektrikums anwesend. Das so erhaltene Material hat aber in der Regel noch keine optimalen elektrischen Eigenschaften. Diese werden erst erhalten, wenn es bei höherer Temperatur in O2 getempert wird, z.B. BST bei 650° C, SBT bei 700-800° C. Anschließend wird die obere Elektrode 26 abgeschieden. Zur weiteren Optimierung der elektrischen Eigenschaften findet in der Regel ein weiterer Temperschritt bei den erwähnten Temperaturen in O2 statt. Besondere Probleme treten hierbei durch Diffusion von Sauerstoff durch die untere, strukturierte Elektrode 24 auf, was nachteiligerweise zur Oxidation des Kontaktplugmaterials und damit zur Unterbrechung der Barrierenschicht zwischen Kontaktplug 16 und unterer Elektrode 24 führen kann. Die Leitfähigkeit und damit die Zuverlässigkeit der gesamten im Halbleiterkörper angeordneten Schaltung ist damit erheblich beeinträchtigt. Um dies zu verhindern, müssen Barrierenschichten zwischen die Kontaktplugs und die untere Elektroden eingefügt werden. Die Zwischenfügung einer solchen Barrierenschicht 28 ist in Fig. 7 schematisch dargestellt.

Bei der Herstellung der oben erwähnten Stackkondensatoren müssen sowohl die untere Elektroden 24 als auch die Barrierenschichten 28 strukturiert werden. Aufgrund der besonderen Stabilität der Barrierenmaterialien können bei diesen Strukturierungsprozessen erhebliche Probleme auftreten. Deshalb wurden bisher diese Barrierenschichten meist in einem Sputterprozeß abgeschieden und dann anschließend separat strukturiert, z. B. durch physikalisches Ätzen.

Das Ziel der vorliegenden Erfindung ist deswegen ein vereinfachtes und trotzdem zuverlässiges Verfahren zum Erzeugen einer Barrierenschicht auf den Kontaktplugs vorzusehen. Des weiteren ist Ziel der Erfindung ein Halbleiterbauelement mit einer solchen Barrierenschichten anzugeben.

Dieses Ziel wird für das Verfahren durch die Merkmale des Anspruchs 1 gelöst. Das Halbleiterbauelement nach der Erfindung zeichnet sich durch die Herstellschritte dieses Verfahrens aus.

Bei dem erfindungsgemäßen Verfahren wird folglich die Barrierenschicht durch chemische Reaktion eines vorstrukturierten, metallischen Übergangsmaterials mit mindestens einem Reaktionspartner erzeugt. Das Verfahren sieht demnach eine In-situ-Herstellung der Barrierenschicht durch chemische Reaktion eines vorstrukturierten Übergangsmetalls oder einer Übergangsmetalllegierung mit mindestens einem geeigneten Reaktionspartner vor. Insbesondere kann hierbei die Umsetzung des Übergangsmetalls oder der Übergangsmetalllegierung mit Nichtmetallwasserstoffen zur Herstellung des Barrierenmaterials angewendet werden.

Zur Vorstrukturierung des metallischen Übergangsmaterials, also des Übergangsmetalls oder der Übergangsmetalllegierung, können unterschiedliche Verfahren angewandt werden. Nach der Vorstrukturierung des metallischen Übergangsmaterials wird in einer Weiterbildung der Erfindung in einer reaktiven chemischen Atmosphäre aus mindestens einem geeigneten Reaktionspartner getempert.

Ein weiterer Vorteil ist, daß eine Abscheidung der Barriere entfällt, weil diese in situ hergestellt wird. Die Abscheidung von Barrierenmaterialien bereitet aufgrund der besonderen Eigenschaften dieser Materialien oft große Schwierigkeiten, während die Abscheidung von Übergangsmetallen ein Standardprozess in der Halbleiterfertigung ist.

Eine mögliche Vorstrukturierung des metallischen Übergangsmaterials kann z. B. durch Abscheiden dieses Übergangsmaterials auf den Halbleiterkörper und ein nachfolgendes Strukturieren, z. B. ein chemisch-physikalischen Gasphasenätzen bzw. ein Trockenätzen, erfolgen. Das Abscheiden des Übergangsmaterials kann beispielsweise durch das bekannte, konventionelle Sputterverfahren bzw. durch Aufdampfen erfolgen, wobei durch geeignete Fototechnik bzw. Ätzschritte aus dieser abgeschiedenen Schicht die erforderlichen Strukturen erzeugt werden. Der Vorteil eines solchen separaten Strukturierungsschrittes des abgeschiedenen Übergangsmaterials ist, daß die Strukturierung von Metallen aufgrund deren höheren chemischen Reaktivität leichter als die Strukturierung von reinen Barrierenschichten durchzuführen ist.

Als Alternative zum Abscheiden des Übergangsmaterials mit anschließendem separatem Strukturierungsschritt kann auch ein selektiver CVD-Prozeß eingesetzt werden, bei dem das Übergangsmaterial nur auf die Kontaktplugs abgeschieden wird, bzw. diese nur etwas überdeckt. Die neben den Kontaktplugs befindliche Oxidschicht, z. B. TEOS, bleibt dagegen frei und wird nicht mit dem Übergangsmaterial bedeckt. Bei dem selektiven CVD-Prozeß wird also das Übergangsmaterial nur selektiv, d. h. ausschließlich, auf ganz bestimmten, zu kontaktierenden Bereichen auf den Halbleiterkörper aufgewachsen.

Das erfindungsgemäße Verfahren nutzt die Tatsache, daß eine Vielzahl von Nichtmetallkohlenwasserstoffen mit metallischen Übergangsmaterialien unter Abspaltung des Wasserstoffs und Freisetzung der Nichtmetallkomponente reagiert. Diese Nichtmetallkomponente kann mit dem metallischen Übergangsmaterial, also dem Übergangsmetall bzw. der Übergangsmetalllegierung, unter Ausbildung einer neuen chemischen Phase reagieren.

Soll als Barrierenschicht beispielsweise eine Nitridübergangsmetallbarrierenschicht vorgesehen werden, kann zur Herstellung von Nitriden das metallische Übergangsmaterial, z. B. Titan Ti, Wolfram W, Molibdän Mo, Tantal Ta, u. a. in Ammoniak NH3 getempert werden. Die Reaktion, also die Abspaltung des Wasserstoffs und die Freisetzung der Nichtmetallkomponente, kommt hierbei bei einer Temperatur von etwa 400° bis 700° C zustande. Die zugehörende Reaktionsgleichung lautet:

$$M + x\ NH3 \rightarrow MNx + 3/2\ x\ H2\ \text{mit } M = Ti, W, Mo, Ta\ ...$$

Eine andere Möglichkeit für eine Barrierenschicht besteht darin, diese als Carbidbarrierenschicht auszubilden. Carbidbarrieren können durch Reaktion von Alkanen mit metallischen Übergangsmaterialien, z. B. Wolfram W, hergestellt werden. Wolfram W reagiert z. B. bei etwa 850° C mit Methan unter Bildung von WC und Abspaltung des Wasserstoffs. Die zugehörende Reaktionsgleichung ist

$$W + CH4 \rightarrow WC + 2\ H2.$$

Es liegt im Rahmen der Erfindung, die Reaktion hierbei durch ein geeignetes Plasma zu unterstützen.

Eine weitere Möglichkeit für eine Barrierenschicht besteht darin, diese als Phosphidbarrierenschicht auszubilden. Phosphidbarrieren entstehen durch Umsetzung des metallischen Übergangsmaterials mit Phosphanen. Ein Beispiel hierfür ist die Umsetzung von Wolfram W mit PH3. Die zugehörende Reaktionsgleichung lautet

$$W + x\ P\ H3 \rightarrow WPx + 3/2\ x\ H2.$$

Schließlich liegt es im Rahmen der Erfindung als Barrierenschicht Übergangsmetallboride durch Reaktion mit B2H6 zu bilden. Die zugehörende Reaktionsgleichung lautet

$$2\ M + x\ B2H6 \rightarrow 2\ MBx + 2x\ H2,$$

wobei M das metallische Übergangsmaterial bezeichnet, also Ti, W, Mo, Ta, usw..

Das erfindungsgemäße Verfahren eignet sich insbesondere zur Herstellung von Halbleiterspeicherbauelementen, bei denen es ganz entscheidend auf die Miniaturisierung der Speicherkondensatoren ankommt. Insbesondere eignet sich das erfindungsgemäße Verfahren zur Herstellung von DRAM- und FRAM-Halbleiterspeicherbauelementen.

Das erfindungsgemäße Verfahren wird nachfolgend im Zusammenhang mit weiteren Figuren naher erläutert. Insgesamt zeigen:

Fig. 1: drei ausschnittsweise Ansichten eines Halbleiterkörpers nach unterschiedlichen Herstellschritten gemäß einem ersten Ausführungsbeispiel der Erfindung,

Fig. 2: ein Schnittbild durch einen anderen Halbleiterkörper, der nach einem zweiten Ausführungsbeispiel des erfindungsgemäßen Verfahren hergestellt ist,

Fig. 3: zwei Schnittbilder eines Halbleiterkörpers nach unterschiedlichen Herstellschritten gemäß einem dritten Ausführungsbeispiel der erfindungsgemäßen Verfahrens,

Fig. 4: drei Schnittbilder eines Halbleiterkörpers nach unterschiedlichen Herstellschritten gemäß einem vierten Ausführungsbeispiel der erfindungsgemäßen Verfahrens,

Fig. 5: eine Schnittansicht durch einen Halbleiterkörper gemäß einem fünften Ausführungsbeispiel der erfindungsgemäßen Verfahrens,

Fig. 6: die bereits erläuterte Schnittansicht durch einen Halbleiterkörper nach dem Stand der Technik,

Fig. 7: eine vergrößerte Detailansicht um den in Fig. 6 strichliert markierten Bereich A in vergrößerter Darstellung.

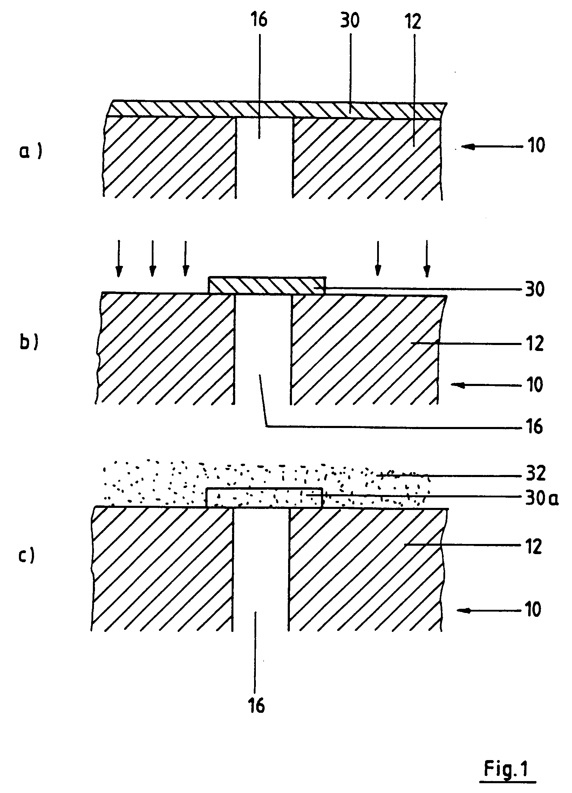

Nach Prozessierung beispielsweise einer Vielzahl von C-MOS-Transistoren mit Bitleitungen, Wortleitungen und Kontaktplugs, jedoch noch ohne Ausbildung der Speicherkondensatoren, wird auf die obere Hauptfläche des Halbleiterkörpers ein metallisches Übergangsmaterial, z. B. Wolfram W, abgeschieden. Dieses Übergangsmaterial ist in Fig. 1a mit dem Bezugszeichen 30 bezeichnet. Wie ersichtlich, berührt hierbei dieses Übergangsmaterial 30 das bis an die Hauptfläche des Halbleiterkörpers 10 reichende Kontaktplug 16 und kontaktiert dieses. Darüber hinaus berührt das Übergangsmaterial 30 auch die um das Kontaktplug 16 herum angeordnete Oxidschicht 12. Das Übergangsmaterial 30 kann beispielsweise durch einen geeigneten Sputterprozeß oder durch Aufdampfen auf die Hauptfläche des Halbleiterkörpers 10 aufgebracht werden. Als Sputtergas kann beispielsweise Argon Ar bei einem Druck von 5 mtorr vorgesehen werden.

Im nächsten Schritt (vgl. Fig. 1b) wird das abgeschiedene Übergangsmaterial 30 strukturiert. Dies kann z. B. durch einen Trockenätzprozeß erfolgen, der in Ar/O2-Plasma erfolgt. Die Strukturierung erfolgt hierbei derart, daß das Übergangsmaterial 30 noch vollständig die obere Seite des Kontaktplugs 16 überlappt, jedoch die übrigen Bereiche der Hauptfläche des Halbleiterkörpers 10, bei denen nur noch die Oxidschicht 12 vorhanden ist, teilweise oder ganz freigelegt sind.

Im nächsten Verfahrensschritt (Fig. 1c) wird der gesamte Halbleiterkörper in Methan CH4 bei etwa 1000° C etwa 30 Minuten lang getempert. Als Ergebnis wird das Übergangsmaterial Wolfram W in die Carbidbarriere WC überfuhrt. Die Carbidbarrierenschicht ist in Fig. 1c mit dem Bezugszeichen 30a markiert, der Reaktionspartner Methan mit dem Bezugszeichen 32. Damit ist die Barrierenschicht auf dem Kontaktplug 16 fertiggestellt. Im nächsten Schritt wird die Elektrodenschicht auf den Halbleiterkörper aufgebracht. Diese Elektrodenschicht bildet die untere Elektrode des Stackkondensators.

Abweichend von dem in Fig. 1 dargestellten Ausführungsbeispiel liegt es im Rahmen des erfindungsgemäßen Verfahrens, einen selektiven CVD-Prozeß anstelle der in Fig. 1a und b gezeigten Verfahrensschritte einzusetzen. Hierbei wird das Übergangsmaterial Wolfram W selektiv auf dem Kontaktplug 16, das z. B. ebenfalls aus Wolfram W bestehen kann, abgeschieden. Dieser selektive CVD-Prozeß kann beispielsweise mit WF6 und H2 im Verhältnis von 1 : 15 erfolgen. Als Prozeßparameter können beispielsweise 400° C und 10 mtorr eingestellt sein. Als Trägergas kann Argon Ar verwendet werden.

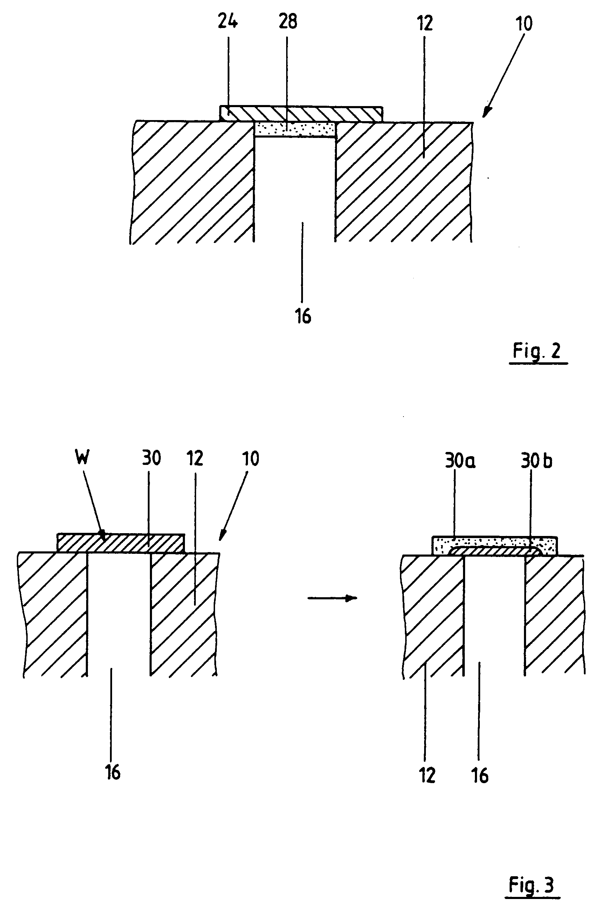

In Fig. 2 ist ebenfalls ein Halbleiterkörper 10 dargestellt, der zur Bildung eines Speicherkondensators geeignet ist. Der lediglich der Deutlichkeit halber ausschnittsweise dargestellte Halbleiterkörper 10 weist wieder eine Oxidschicht 12 auf, in der ein Kontaktplug 16 sitzt. Im Gegensatz zum Ausführungsbeispiel von Fig. 1 reicht der Kontaktplug 16 jedoch nicht vollständig bis an die Hauptfläche des Halbleiterkörpers 10 heran, sondern endet etwas kurz darunter. Auf der Hauptfläche des Halbleiterkörpers 10 sitzt bereits flächig die erste Elektrodenschicht 24 auf. Zwischen dieser ersten Elektrodenschicht 24, die die untere Elektrode für den Speicherkondensator bildet, und der Oberseite des Kontaktplugs 16 sitzt die Barrierenschicht 28, die nach dem erfindungsgemäßen Verfahren hergestellt wurde. Die Barrierenschicht 28 ist also ausgehend von der oberen Hauptfläche des Halbleiterkörpers 10 etwas in Richtung Kontaktplug 16 zurückversetzt angeordnet.

Eine andere Ausführungsform der Erfindung ist anhand der beiden teilweisen Schnittansichten eines Halbleiterkörpers 10 in Fig. 3 dargestellt. Das Übergangsmetall ist in diesem Ausführungsbeispiel nicht ganz in die Barrierenschicht 28 überführt worden, sondern nur eine erste untere Lage. In der Schnittansicht von Fig. 3 links ist auf die obere Hauptfläche des Halbleiterkörpers 10 - wie im Zusammenhang mit Fig. 1 erläutert - ein metallisches Übergangsmaterial 30 aufgebracht. Im dargestellten Ausführungsbeispiel von Fig. 3 ist Wolfram W selektiv auf das Kontaktplug 16 abgeschieden worden. Im nächsten Schritt, den Fig. 3 rechts zeigt, ist das metallische Übergangsmaterial 30, also Wolfram, durch chemische Reaktion mit mindestens einem Reaktionspartner in eine zweilagige Schicht überfuhrt, nämlich eine untere unveränderte Schicht aus metallischem Übergangsmaterial 30b, die mit dem Kontaktplug 16 direkt in Verbindung steht und eine darüberliegende Lage, die die Barrierenschicht 30a bildet. Eine derartige Struktur kann beispielsweise dadurch erreicht werden, daß der Temperschritt kürzer gewählt ist, so daß das aufgebrachte strukturierte metallische Übergangsmaterial nicht vollständig in die Barrierenschicht überführt werden kann.

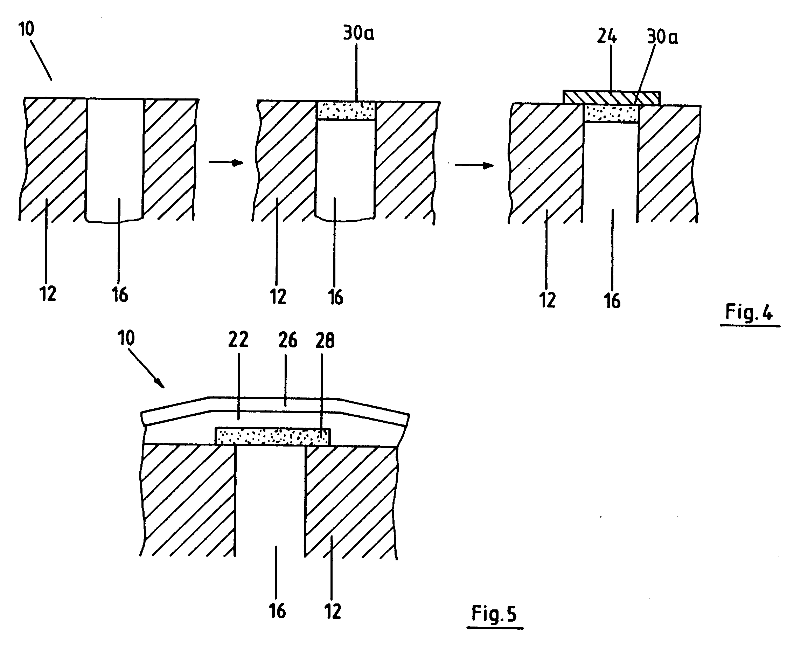

Fig. 4 zeigt drei Schnittbilder von Halbleiterkörpern nach unterschiedlichen Herstellschritten. Im Ausführungsbeispiel von Fig. 4 besteht der Kontaktplug 16 aus Wolfram. Der Kontaktplug 16 reicht bis an die obere Hauptfläche des Halbleiterkörpers 10 heran. Durch Tempern des Halbleiterkörpers in CH4 wird der obere Teil des Kontaktplugs 16 in WC überführt. Dieser Bereich ist mit Punkten markiert und mit Bezugszeichen 30a gekennzeichnet. Der mit dem Bezugszeichen 30a markierte Bereich besteht wiederum aus WC und dient als Barrierenschicht 30a. Auf der Hauptfläche des Halbleiterkörpers 10 kann dann beispielsweise die unterste Elektrode 24 eines zu realisierenden Speicherkondensators aufgebracht werden.

In Fig. 5 ist eine weitere Variante des Halbleiterkörpers dargestellt. Im Unterschied zu den vorangegangenen Ausführungsbeispielen wird zur Bildung eines Speicherkondensators auf die untere Elektrode, die den Kontaktplug 16 mit der Dielektrikumsschicht verbindet, verzichtet. Die untere Elektrode wird nämlich gemäß diesem Ausführungsbeispiel weggelassen und die Dielektrikumsschicht 22 direkt auf die Barrierenschicht 28 aufgebracht. Auf der Dielektrikumsschicht 22 sitzt die Elektrodenschicht 26, die die obere Elektrode eines Speicherkondensators bildet.

Bezugszeichenliste

10  Halbleiterkörper
12  Oxidschicht, TEOS
14  dotierte Wanne
16  Kontaktplug

| 17 | Wortleitung |
| 18 | Bitleitung |
| 22 | Dielektrikumsschicht |
| 24 | erste Elektrodenschicht |
| 26 | zweite Elektrodenschicht |
| 28 | Barrierenschicht |
| 30 | metallisches Übergangsmaterial |
| 30a | in Barrierenmaterial überfuhrtes Übergangsmaterial |
| 30b | Lage aus metallischem Übergangsmaterial |
| 32 | Reaktionspartner |
| A | Detail |

**Patentansprüche**

1. Verfahren zum Herstellen einer Barrierenschicht auf einem in einem Halbleiterkörper angeordneten und mindestens annähernd bis zu einer Hauptfläche des Halbleiterkörpers ragenden Kontaktplug,
**dadurch gekennzeichnet**, daß die Barrierenschicht (28; 30a) durch chemische Reaktion eines vorstrukturierten, metallischen Übergangsmaterials (30) mit mindestens einem Reaktionspartner (32) gebildet wird.

2. Verfahren nach Anspruch 1,
**dadurch gekennzeichnet**, daß das vorstrukturierte metallische Übergangsmaterial (30) in einer reaktiven chemischen Atmosphäre aus dem mindestens einem Reaktionspartner getempert wird.

3. Verfahren nach Anspruch 1 oder 2,
**dadurch gekennzeichnet**, daß die Vorstrukturierung des Übergangsmaterials (30) durch Abscheiden des Übergangsmaterials (30) auf den Halbleiterkörper (10) und anschließendem Strukturieren dieses abgeschiedenen Übergangsmaterials (30) erfolgt.

4. Verfahren nach Anspruch 3,
**dadurch gekennzeichnet**, daß die Strukturierung des Übergangsmaterials (30) durch chemischphysikalisches Gasphasenätzen bzw. durch einen Trockenätzprozeß erfolgt.

5. Verfahren nach Anspruch 1 oder 2,
**dadurch gekennzeichnet**, daß die Vorstrukturierung des Übergangsmaterials (30) mittels eines selektiven CVD-Prozesses durchgeführt wird, bei dem das metallische Übergangsmaterial (30) lokal begrenzt auf den Kontaktplugs (16) des Halbleiterkörpers (10) abgeschieden wird.

6. Verfahren nach einem der Ansprüche 1 bis 5,
**dadurch gekennzeichnet**, daß als Reaktionspartner Nichtmetallkohlenwasserstoffe eingesetzt werden.

7. Verfahren nach einem der Ansprüche 1 bis 6,
**dadurch gekennzeichnet**, daß die Barrierenschicht (28; 30a) als Nitridübergangsmetallschicht zur Bildung einer Sauerstoffbarriere ausgebildet wird, indem das metallische Übergangsmaterial (30) in Ammoniak bei einer Temperatur von etwa 400° bis 700° C getempert wird.

8. Verfahren nach einem der Ansprüche 1 bis 7,
**dadurch gekennzeichnet**, daß durch Reaktion von Alkanen mit dem metallischen Übergangsmaterial (30) eine Carbidbarrierenschicht als Barrierenschicht (28; 30a) ausgebildet wird.

9. Verfahren nach Anspruch 8,
**dadurch gekennzeichnet**, daß die Carbidbarrierenschicht durch Tempern von Wolfram W bei einer Temperatur von bis etwa 1000° C mit Methan gebildet wird.

10. Verfahren nach Anspruch 9,
**dadurch gekennzeichnet**, daß der Tempervorgang etwa 30 Minuten lang dauert.

11. Verfahren nach einem der Ansprüche 1 bis 6,
**dadurch gekennzeichnet**, daß durch Umsetzung des metallischen Übergangsmaterials (30) mit Phosphanen eine Phosphidbarrierenschicht als Barrierenschicht (30a) ausgebildet wird.

12. Verfahren nach einem der Ansprüche 1 bis 6,
   **dadurch gekennzeichnet**, daß durch Reaktion von B2H6 mit dem metallischen Übergangsmaterial Übergangsmetallboride als Barrierenschicht (30) ausgebildet werden.

13. Verfahren nach einem der Ansprüche 1 bis 12,
   **dadurch gekennzeichnet**, daß ein oberes Ende des Kontaktplugs (16) unterhalb der Hauptfläche des Halbleiterkörpers endet und in Richtung Hauptfläche des Halbleiterkörpers (10) die Barrierenschicht (28; 30a) eingebracht ist.

14. Verfahren nach einem der Ansprüche 1 bis 13,
   **dadurch gekennzeichnet**, daß nach dem Aufbringen des metallischen Übergangsmaterials (30) auf oder in den Halbleiterkörper (10) das metallische Übergangsmaterial (30) nur teilweise in die Barrierenschicht (28; 30a) überführt wird.

15. Verfahren nach Anspruch 1 oder 2,
   **dadurch gekennzeichnet**, daß der Kontaktplug (16) aus dem metallischen Übergangsmaterial (30) besteht, daß der Halbleiterkörper (10) einem Temperschritt unterzogen wird, so daß ein zur Hauptfläche gewandter oberer Bereich des Kontaktplugs (16) in eine Barrierenschicht (28; 30a) überführt wird.

16. Verfahren nach einem der Ansprüche 1 bis 15,
   **dadurch gekennzeichnet**, daß bei Bildung eines Speicherkondensators die Dielektrikumsschicht (22) direkt mit der Barrierenschicht (28) in Kontakt steht und keine dazwischen liegende Elektrodenschicht vorgesehen wird.

17. Halbleiterbauelement nach einem der Ansprüche 1 bis 16,
   **dadurch gekennzeichnet**, daß dieses wenigstens eine nach den Verfahrensansprüchen 1 bis 16 hergestellte Barrierenschicht aufweist.

18. Halbleiterbauelement nach Anspruch 16,
   **dadurch gekennzeichnet**, daß in dem Halbleiterkörper (10) eine Vielzahl von Speicherkondensatoren angeordnet sind.

Fig.1

Fig. 2

Fig. 3

Fig. 4

Fig. 5

Stand der Technik

Fig. 6

Stand der Technik

Fig. 7